# EUROPEAN PATENT SPECIFICATION

(11) **EP 0 989 613 B1**
(45) Date of publication and mention of the grant of the patent: **04.05.2005**
(21) Application number: 99112440.5
(22) Date of filing: 30.06.1999
(51) Int. Cl.: H01L 29/786, H01L 21/336

(54) **SOI transistor with body contact and method of forming same**
SOI-Transistor mit einem Substrat-Kontakt und Verfahren zu dessen Herstellung
Transistor SOI ayant un contact de substrat et sa méthode de fabrication

(30) Priority: 29.08.1998 EP 98116406
(43) Date of publication of application: 29.03.2000
(73) Proprietor: International Business Machines Corporation, Armonk, NY 10504 (US)
(72) Inventor: Kröll, Karl-Eugen, Dr. Dipl.-Phys., 71155 Altdorf (DE); Pille, Jürgen, Dipl.-Ing., 70199 Stuttgart (DE); Schettler, Helmut, Dipl.-Ing., 72135 Dettenhausen (DE)
(74) Representative: Rach, Werner, Dr.

(56) References cited:
- DE-A- 19 654 280
- PATENT ABSTRACTS OF JAPAN vol. 1998, no. 01, 30 January 1998 (1998-01-30) -& JP 09 246562 A (NEC CORP), 19 September 1997 (1997-09-19)
- OH C-B ET AL: "The effect of body contact arrangement on thin SOI MOSFET characteristics" MICROELECTRONIC ENGINEERING, vol. 28, no. 1, 1995, pages 467-470, XP004011937 ELSEVIER PUBLISHERS BV, AMSTERDAM, NL ISSN: 0167-9317
- PATENT ABSTRACTS OF JAPAN vol. 1998, no. 14, 31 December 1998 (1998-12-31) -& JP 10 242470 A (TOSHIBA CORP), 11 September 1998 (1998-09-11)

## Description

The present invention refers in general to CMOS semiconductor-on-insulator, eg. Silicon-On-Insulator (SOI), technology and, more specifically, to a method of forming an SOI FET transistor having a body contact.

### Field of the Invention

Silicon-on-Insulator (SOI) technology is becoming extremely attractive for future high performance low power applications. Partially depleted SOI technology offers a variety of practical advantages such as ease of manufacturing, better control of threshold voltage and tighter control of short channel effects than fully depleted devices.

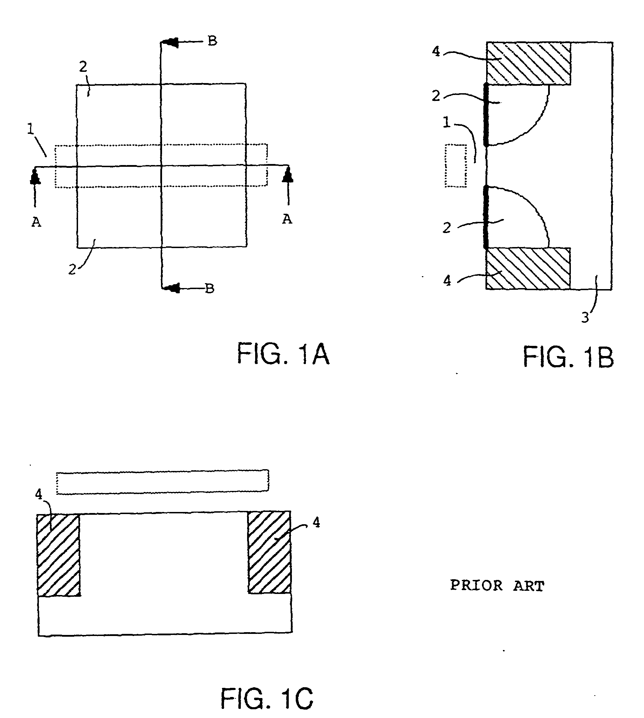

In the traditional CMOS bulk process (cf. Fig. 1A to 1C) a transistor is formed by a polysilicon gate 1 and the source/drain diffusion region 2 to the left and right of the gate. The region 3 under the gate is the active area of the device, p-type for a n-FET device, n-type for a p-FET.

In the following an n-FET is taken to describe the device characteristics but they are also applicable to a p-FET with inverted polarities and conductivity types.

The region under the gate is also called the body 3 of the device. Source and drain are n-type diffusions and are disconnected by the p-type body. A positive voltage on the gate converts the p-type silicon thereunder to n-type and forms a thin channel between source and drain, thus a current can flow between source and drain.

Adjacent devices are separated by a trench oxide 4 (STI - silicon trench isolation) to increase density and prevent latch-up effects (parasitic bipolar current).

The performance of a CMOS circuit mainly depends on the maximum current of the device and the total capacitance it has to charge. The current is a complex function of many technology characteristics but as a first approximation the channel length and the threshold voltage Vₜ are the key parameters. The channel length is defined as the distance between source and drain, the current increases with a smaller channel length. The threshold voltage is the voltage needed on the gate to build the channel. While the channel length is of a physical nature, Vₜ is a function of many independent physical parameters like gate oxide thickness, doping concentrations and electrical conditions like the body voltage. A positive body voltage lowers the threshold so that the device can switch earlier and the maximum current is increased. The device is faster but also has a higher leakage. To guarantee a reliable function and prevent parasitic bipolar currents between devices through npnp structures (latch-up effect) the body of the device is usually tied to ground through the backside of the silicon wafer or by adjacent body contacts.

Wiring and device capacitance contribute to the total capacitance a device has to drive. The device caps are mainly the gate-to-body cap (C_{g}), the gate-to-source/drain overlap caps (C_{gs}, C_{gd}) and the source/drain diffusion caps (Cₛ, C_{d}).

In contrast to the bulk technology, the SOI technology employs a layer of silicon overlying an insulating material (usually silicon oxide) on a supporting bulk wafer.

Thus, the active area now is in the top silicon layer on top of the buried oxide. The thickness is smaller than the depth of the STI oxide so that the two isolations touch each other. This results in totally isolated devices, there is no longer any connection to the body through the backside of the wafer. The STI acts as a wall surrounding the devices, the buried oxide is the isolating floor.

The body of each device is floating. During current flow through the device impact ionization into the body loads up the body. The voltage level depends on the history of the device, i.e., how often it has switched and the total capacitance it had to drive. The minimum is usually ground for an n-type device, the maximum is limited by the forward diode behavior of the source/drain diffusion and is in the order of a few hundred millivolts. As already mentioned with respect to the bulk technology the threshold voltage and the maximum current of a device are a function of the body voltage. In average the body has a positive potential which lets the device switch earlier because of the lower Vₜ, the current reaches the maximum value faster and the maximum is higher. While a current flows through the device, more charge leaks into the body. Because of impact ionization at the drain diode of the device, the potential increases and, in turn, also the current (kink effect). As a rough estimation all of these effects result in about (10+x)% performance improvement.

Negative effects are the increased leakage currents due to the reduced Vₜ and a bipolar n-p-n structure (source-body-drain) which can be electrically activated by a positive basis, i.e., body potential and results in additional leakage.

Because the body potential now is a function of the device history, the behavior changes over time, there is no longer a fix delay for a specific circuit, it is only possible to assign a min/max value to each circuit. This, however, causes many problems: analog circuits are hard to control, dynamic logic has to fight with race conditions and increased leakage, the min/max delay characteristics have to be determined, chip integration has to respect a worst case scenario for min/max delay combinations on all the logical units, etc. In some situation where an exact timing is important (race conditions in dynamic logic) or symmetrical devices are needed (sense amplifier in cache arrays) a body contact gives control.

SOI also affects the device capacitance. The source/drain diffusions touch the buried oxide which eliminates the source/drain diffusion capacitance, it nearly goes down to zero. In cases where a circuit has to drive a long wire, the total capacitance is mainly the wiring capacitance (which is identical to the bulk process). The diffusion contribution is very small and in total there is nearly no change. But in case of dotted-or situations (like multiplexors or bit lines in arrays) the diffusion has a significant contribution to the total capacitance. As a rule of thumb one can expect an improvement of up to 10% in average due to the elimination of the diffusion capacitance.

In total this results in a 20% performance advantage of SOI over bulk technology.

### Prior Art

The body of an SOI device is totally isolated by the buried oxide and the shallow trench isolation. In a normal n-FET device there is no direct access to the body because the source/drain diffusions are n-type while the body is p-type. In order to get access to the body an additional p-type region must be provided which can be contacted from the surface.

Several proposals have been made in the art concerning the provision of SOI transistors including body contacts. In US-A-5,489,792, Hu et al. propose an SOI MOSFET having improved electrical characteristics, this MOSFET including a low barrier body contact under the source region, and alternatively under the drain region, to facilitate collection and removal of current carriers generated by impact ionization.

Bronner et al., in US-A-5,606,188, propose an SOI DRAM including a direct body contact between the SOI layer and the silicon substrate, and field-shield isolation positioned on the surface of the SOI structure which extends over the direct body contact.

In US-A-5,729,039 to Beyer et al., there is disclosed an SOI transistor having a self-aligned body contact formed through an extension to the gate, thereby forming the body contact with minimal increase in area and also avoiding the need to tie the source to the body.

As already mentioned before, dynamic floating body effects have generated considerable problems. Controlling the body voltage has become an issue in situations where a mismatch in threshold voltages between devices (e.g., SRAM sense-amplifiers) or history dependent delays are not acceptable.

An SOI MOS transistor is diclosed in US-A-5,185,280 to Houston et al., that has an implanted region of the same conductivity type as the body underneath one or both of the extended drain and source portions of the drain and the source with and without a body-to-source (BTS) contact or a general body contact. The floating body effects are said to be minimized by this arrangement. One embodiment is a method of controlling the body voltage by contacting it from the edge of the transistor. The body is elongated at the edge of the transistor and a contact is made to the body. Thus, a polysilicon T-shape acts as the insulation between the p-region and the n-source/drain region.

However, just because of this T-shape, the gate capacitance is increased by about 20% (and more for smaller devices), because it represents an additional area which is parasitic and thus increases the capacitance and leads to a slowdown of the transistor, resulting in a performance reduction of about the same order of 20%.

As an example, Table 1 shows the gate capacitance and delay of a 18/9 µm CMOS inverter (body floating), wherein RF represents the delay rising input to falling output and FR represents the delay falling input to rising output.

**Table 1**

| | no body contact | with body contact | difference |
|---|---|---|---|
| gate capac. | 41.7 fF | 49.4 fF | 18.5% |
| delay RF | 38.2 ps | 45.7 ps | 19.6% |
| delay FR | 42.6 ps | 46.6 ps | 9.4% |
| delay total | 80.8 ps | 92.3 ps | 15.4% |
| fF = femto Farad; ps = pico seconds | | | |

DE-A-196 54 280 and Patent Abstracts of Japan, vol. 1998, no. 1, January 1988, both disclose an SOI field-effect transistor having a body contact isolated from a source/drain region by a shallow trench formed in the body portion of the transistor, said trench being actually complementary to the oxide isolation region disposed between, e.g., the source/drain region and the body contact or disposed between the source region and the body contact.

In Microelectronic Engineering, vol. 28, no. 1, 1995, pages 467-470, the effect of various kinds of body contact arrangement types on the electrical characteristics of SOI MOSFETs fabricated on SIMOX (Separation by Implanted Oxygen) wafer is disclosed.

### Objects of the invention

It is therefore an object of the present invention to provide a method of making a body contact for an SOI CMOS device without any increase in capacitance and delay.

It is a further object to provide a method of making such a body contact that is self-aligning with respect to the width of the device.

It is still another object of the present invention to provide a method of making such a body contact that does not require additional process steps.

These and other objects are achieved by the method according to claim 1.

Further advantageous embodiments are shown in the dependent claims.

Due to the fact that the T-shape has to overlap the diffusion region for process tolerance reasons, a minimum distance from the rail of the T-shape to the adjacent geometries is required (polysilicon to polysilicon and polysilicon to diffusion). Using the present invention eliminates the rail and his overlap and thus results in a higher density. Furthermore, it allows an easy migration of designs in the traditional bulk process to SOI because the device area is not enlarged by the T-shape and the design effort to adjust the layout is minimized.

### Short description of the drawings

- Fig. 1A: is a schematic view of a prior art n-FET fabricated in CMOS bulk technology;
- Fig. 1B: represents a view along line a-a of Fig. 1A;
- Fig. 1C: represents a view along line b-b of Fig. 1A;
- Fig. 2A: schematically shows an n-FET fabricated in CMOS SOI technology with a body contact according to the state of the art;
- Fig. 2B: represents a view along a-a of Fig. 2A;
- Fig. 2C: represents a view along b-b of Fig. 2A;
- Fig. 3A: schematically depicts an n-FET fabricated in CMOS SOI technology according to the method of the present invention;
- Fig. 3B: represents a view along a-a of Fig. 3A;
- Fig. 3C: represents a view along b-b of Fig. 2A; and
- Figs. 4A-4F: schematically depict the method steps of fabricating a self-aligned separation trench according to the method of the present invention.

### Detailed description of the invention

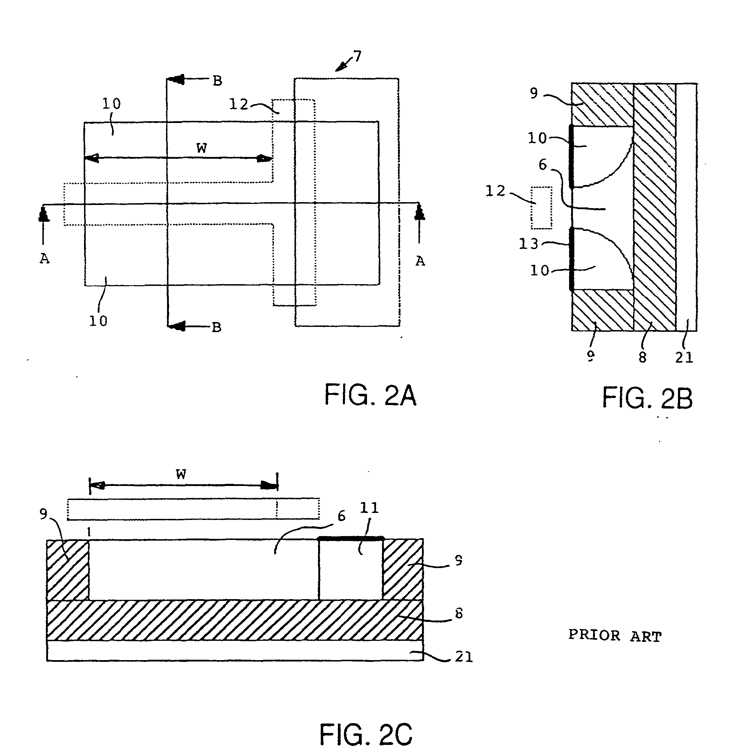

Referring now to Fig. 2, there is shown an n-FET fabricated in CMOS SOI technology with a body contact according to the state of the art. Whereas in a traditional CMOS bulk technology the body of a transistor is connected through the backside of the wafer or by an adjacent body contact, the body 6 of the SOI device 7 is totally isolated by the buried oxide 8 and the shallow trench isolation (STI) 9. In the n-FET device shown there is no direct access to the body 6 because the source/drain diffusions 10 are n-type while the body 6 is p-type. It has to be mentioned that the same holds true for a p-FET device where n- and p-regions are changed. In order to get access to the body, an additional p-type region 11 must be provided which can be contacted from the surface. In order to prevent short circuits, a polysilicon T-shape 12 acts as the isolation between this p-region 11 and the n-source/drain region 10, i.e., it disconnects the salicided diffusion surfaces 13. It has to be mentioned that the whole T-shape is made of a single material, preferably polysilicon. Due to the fact that the T-shape lies in a different plane than the diffusion of the transistor (cf. Figs. 2B and 2C), it is possible that these two planes may shift with respect to each other, leading to unwanted and unfavorable tolerances.

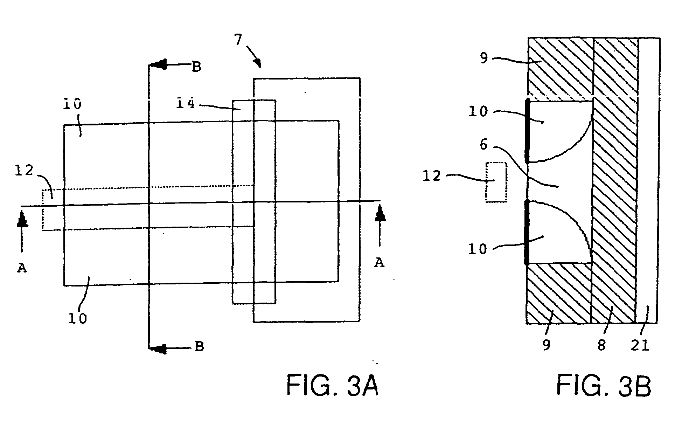

Looking at Fig. 3, the present invention proposes a second STI isolation 14 (so that the buried oxide isn't touched) instead of separating the source/drain regions 10 and the body contact by a polysilicon T-shape 12. This shallow oxide prevents the generation of the salicide in the open diffusion area thereby isolating the source/drain and body contact regions. It should be noted that the second STI should be as shallow as possible to guarantee a good electrical contact from the surface to the body. The minimum depth is mainly driven by the tolerance and uniformness of the polishing process step after the STI oxide generation. In general, the depth of STI 14 is much less than the active Si thickness ("x" in Fig. 3C).

When looking at Figs. 2 and 3, it can be seen that, functionally, the rail of the "T" in Fig. 2 has been transferred from the polysilicon plane into the oxide trench plane of the transistor. Thus, the mask alignment tolerance between the two planes can no longer contribute to the electrically important channel width tolerance ("w" in Figs. 2A and 2C as well as in Figs. 3A and 3C) of the FET.

Since there is no extended gate, there is also no increase in gate capacitance and therefore no delay increase and performance loss.

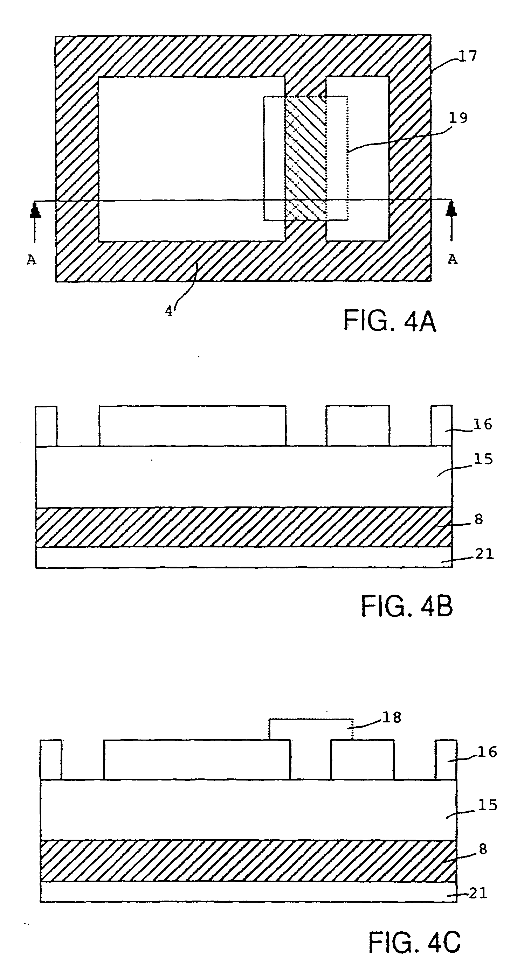

The skilled worker can think of many ways to fabricate the separation trench. However, special advantages are achieved if the separation trench 14 is self-aligned as compared to the STI trenches 9 of the FET. One advantageous method how to fabricate such a self-aligned separation trench is shown in Figs. 4A to 4F.

The buried oxide 8 is fabricated first on top of substrate 21. This does not require any photolithographic process step and can be done by ion implantation of oxygen into a blank silicon wafer, followed by proper annealing steps, which need not be described in any great detail. The oxygen is implanted so deep below the surface that the buried oxide 8 forms below the surface. By this processing step the top part of the silicon wafer becomes electrically isolated from the bottom part 21. Silicon 15 will be the active layer for the n-FET and p-FET devices.

Next the silicon surface is covered with an oxide (SiO₂) layer 16. Using photolithographic techniques the STI-mask pattern 17 is then applied and etched into layer 16 with the etching being stopped at the interface to layer 15. In this and subsequent processing steps a reactive ion etching technique is assumed which predominantly etches into the depth and not to the sides.

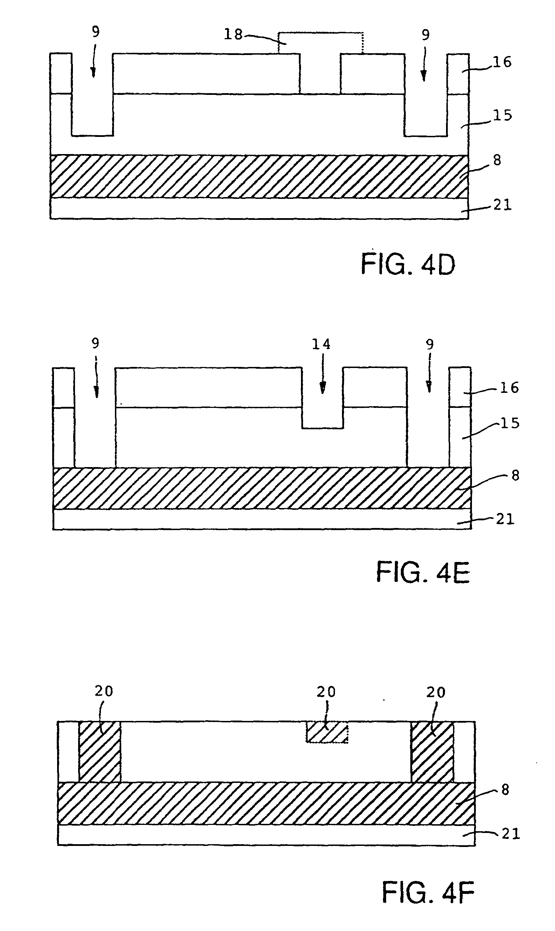

The wafer is then coated with a photoresist layer 18. This layer (after proper patterning) is intended to protect the ST regions (14 in Fig. 3C) while the STI trenches (9 in Fig. 4D) are being etched. The pattern to serve this purpose is the blockout mask pattern for the separation trench (in the following denoted as STIBO pattern, 19 in Fig. 4A). By photolithography this pattern is transferred to the photoresist layer 18 such that layer 18 gets removed outside the STIBO regions but remains present within these regions.

Now the STI trenches 9 are etched down almost to the buried oxide layer 8 using a technique which attacks silicon but not the oxide and the photoresist which covers the STIBO regions. After that the photoresist 18 is removed without attacking layers underneath.

Now the wafer is ready to etch the ST trench 14 down to the desired depth 14 in a similar way as was done for the STI trenches 9. At the same time the STI trenches 9 are etched deeper to reach the buried oxide (8 in Fig. 4E). Processing proceeds with removing oxide layer 16 while leaving silicon unattacked.

Next the wafer is covered by SiO₂ 20 or some other material which fills both the ST trench 14 and the STI trenches 9. In a subsequent chemical-mechanical polishing step the SiO is removed from the silicon surface but remains in the ST and STI trenches. This is shown in Fig. 4F.

From now on, standard FET processing can continue to complete the transistor.

By the technique described above the ST and STI trenches are self-aligned to each other because they are both defined by the same mask which patterned layer 16.

The layer 16 and 18 materials do not necessarily have to be SiO₂ and photoresist. Only the etching and selective etch stopping techniques must be applicable to them as described above.

The new separation trench feature can thus be implemented by just applying an additional photolithographic mask which defines the pattern for the ST layer with an uncritical block out mask. No additional process step is necessary.

Thus the present invention is able to provide a body contact for CMOS SOI transistors without increase in gate capacitance and therefore without increase of delay and performance loss.

It has to be noted that the present invention is applicable to a broad variety of SOI, e.g., heteroepitaxy, such as SOS, beam or laser recrystallization, epitaxial lateral overgrowth, lateral solid phase epitaxy, polysilicon, bond and etch back, and single silicon separation. This invention is also applicable to other semiconductor materials on insulator.

## Claims

1. Method for fabricating a semiconductor-on-insulator field effect transistor (7) isolated by a shallow isolation trench (9) located in a shallow isolation trench region and having source and drain regions (10) separated by a gate (12) extending along a gate axis, a body region (6) disposed below said gate (12) and a body contact region (11), in which said body contact region (11) is isolated from said gate (12) and said source and drain regions (10) by a body isolation trench (14) located in a body isolation trench region of said transistor, **characterized by** the steps of
a) preparing a semiconductor-on-insulator stucture including a semiconductor layer (15), having a semiconductor layer thickness, disposed above and in contact with a buried insulating layer (8) having an insulating layer thickness;
b) depositing a trench pattern layer (16) on the surface of said semiconductor layer (15);
c) etching a shallow trench isolation pattern into said pattern layer (16), thereby exposing said semiconductor layer (15) in said shallow trench isolation pattern at said shallow isolation trench region and said body isolation trench region;
d) covering said body isolation trench region with a masking layer (18) not covering said shallow isolation trench region;
e) etching said semiconductor layer (15) in said shallow trench isolation pattern down to a first depth almost said semiconductor layer thickness;
f) removing said masking layer (18) and etching said semiconductor layer (15) down to said buried insulating layer (8) in said shallow isolation trench region, whereby, simultaneously with the etching of said shallow isolation trench region, said body isolation trench region is etched to a body isolation depth less than said semiconductor layer thickness, so that said shallow isolation trench (9) and said body isolation trench (14) are respectively formed in said shallow isolation trench region and said body isolation trench region, and a conductive path extends in said semiconductor layer (15) along said gate axis from said body region (6) to said body contact region (11);
g) filling said trenches (9, 14) formed in step f) with an insulating material (20) and planarizing the surface of the resulting structure; and
h) completing said transistor.

2. Method according to claim 1, wherein said semiconductor layer (15) is a silicon layer.

3. Method according to claim 1 or 2, wherein said buried insulating layer (8) is a buried oxide layer produced by ion implantation of oxygen into a blank silicon wafer.

4. Method according to any one of claims 1 to 3, wherein said etching steps are carried out using reactive ion etching.

5. Method according to any one of claims 1 to 4, wherein said insulating material (20) is SiO₂.

6. Method according to any one of the preceding claims, wherein said planarizing step is carried out by chemical-mechanical polishing.

## Patentansprüche

1. Verfahren zur Herstellung eines Halbleiter-auf-Isolator-Feldeffekttransistors (7), der durch einen in einer flachen Isolationsgrabenzone befindlichen flachen Isolationsgraben (9) isoliert ist und Source- und Drain-Zonen (10), die durch eine sich entlang einer Gate-Achse erstreckende Gate-Elektrode (12) voneinander getrennt sind, sowie eine unterhalb der Gate-Elektrode (12) und der Substratkontaktzone (11) befindliche Substratzone (6) aufweist, wobei die Substratkontaktzone (11) von der Gate-Elektrode (12) und den Source- und Drain-Zonen (10) durch einen in einer Substratisolationsgrabenzone des Transistors gelegenen Substratisolationsgraben (14) isoliert ist,
**gekennzeichnet durch** die folgenden Schritte:
a) Herstellen einer Halbleiter-auf-Isolator-Struktur mit einer Halbleiterschicht (15), welche eine Halbleiterschichtdicke aufweist und über einer vergrabenen Isolierschicht (8) aufgebracht ist, welche eine Isolierschichtdicke aufweist und sich in Kontakt mit der Halbleiterschicht (15) befindet;
b) Abscheiden einer Grabenschichtstruktur (16) auf der Oberfläche der Halbleiterschicht (15);
c) Ätzen einer flachen Isolationsgrabenstruktur in die strukturierte Schicht (16), sodass die Halbleiterschicht (15) in der flachen Isolationsgrabenstruktur im Bereich des flachen Isolationsgrabens und im Bereich des Substratisolationsgrabens freigelegt wird;
d) Beschichten des Bereichs des Substratisolationsgrabens mit einer Maskenschicht (18), welche den Bereich des flachen Isolationsgrabens nicht bedeckt;
e) Ätzen der Halbleiterschicht (15) in der flachen Isolationsgrabenstruktur bis zu einer ersten Tiefe hinab, die fast der Dicke der Halbleiterschicht entspricht;
f) Entfernen der Maskenschicht (18) und Ätzen der Halbleiterschicht (15) bis zur vergrabenen Isolierschicht (8) im Bereich des flachen Isolationsgrabens hinab, wobei zusammen mit dem Bereich des flachen Isolationsgrabens auch der Bereich des Substratisolationsgrabens bis zu einer Substratisolationstiefe hinab geätzt wird, die kleiner als die Halbleiterschichtdicke ist, sodass der flache Isolationsgraben (9) und der Substratisolationsgraben (14) im Bereich des flachen Isolationsgrabens bzw. im Bereich des Substratisolationsgrabens gebildet wird und sich in der Halbleiterschicht (15) ein leitender Pfad von der Substratzone (6) entlang der Gate-Elektrodenachse zur Substratkontaktzone (11) erstreckt;
g) Ausfüllen der in Schritt f) gebildeten Gräben (9, 14) mit einem Isoliermaterial (20) und Planarisieren der Oberfläche der entstehenden Struktur; und
h) Fertigstellen des Transistors.

2. Verfahren nach Anspruch 1, bei welchem die Halbleiterschicht (15) eine Siliciumschicht ist.

3. Verfahren nach Anspruch 1 oder 2, bei welchem die vergrabene Isolierschicht (8) eine vergrabene Oxidschicht ist, die durch Ionenimplantation von Sauerstoff in einen unbearbeiteten Siliciumwafer erzeugt wird.

4. Verfahren nach einem der Ansprüche 1 bis 3, bei welchem die Ätzschritte mittels reaktiven Ionenätzens ausgeführt werden.

5. Verfahren nach einem der Ansprüche 1 bis 4, bei welchem das Isoliermaterial (20) SiO₂ ist.

6. Verfahren nach einem der vorangehenden Ansprüche, bei welchem der Planarisierungsschritt durch chemisch-mechanisches Polieren erfolgt.

## Revendications

1. Procédé de fabrication d'un transistor à effet de champ à semiconducteur sur isolant (7) isolé par une tranchée d'isolement peu profonde (9) située dans une région de tranchée d'isolement peu profonde et comportant des régions de source et de drain (10) séparées par une grille (12) qui s'étend le long d'un axe de grille, une région de corps (6) disposée sous ladite grille (12) et une région de contact de corps (11) dans lequel ladite région de contact de corps (11) est isolée de ladite grille (12) et desdites régions de source et de drain (10) par une tranchée d'isolement de corps (14) située dans une région de tranchée d'isolement de corps dudit transistor, **caractérisé par** les étapes consistant à
a) préparer une structure à semiconducteur sur isolant comprenant une couche de semiconducteur (15), présentant une épaisseur de couche de semiconducteur, disposée au-dessus d'une couche isolante enterrée (8) présentant une épaisseur de couche isolante, et en contact avec celle-ci,
b) déposer une couche de motif de tranchée (16) sur la surface de ladite couche de semiconducteur (14),
c) graver un motif d'isolement à tranchée peu profonde dans ladite couche de motif (16), en exposant de ce fait ladite couche de semiconducteur (15) dans ledit motif d'isolement à tranchée peu profonde au niveau de ladite région de tranchée d'isolement peu profonde et de ladite région de tranchée d'isolement de corps,
d) recouvrir ladite région de tranchée d'isolement de corps avec une couche de masquage (18) sans recouvrir ladite région de tranchée d'isolement peu profonde,
e) graver ladite couche de semiconducteur (15) dans ledit motif d'isolement à tranchée peu profonde jusqu'à une première profondeur qui est presque ladite épaisseur de couche de semiconducteur,
f) enlever ladite couche de masquage (18) et graver ladite couche de semiconducteur (15) jusqu'à ladite couche isolante enterrée (8) dans ladite région de tranchée d'isolement peu profonde, grâce à quoi, simultanément à la gravure de ladite région de tranchée d'isolement peu profonde, ladite région de tranchée d'isolement de corps est gravée à une profondeur d'isolement de corps inférieure à ladite épaisseur de couche de semiconducteur, de sorte que ladite tranchée d'isolement peu profonde (9) et ladite tranchée d'isolement de corps (14) soient formées respectivement dans ladite région de tranchée d'isolement peu profonde et ladite région de tranchée d'isolement de corps, et une ligne conductrice s'étend dans ladite couche de semiconducteur (15) le long dudit axe de grille depuis ladite région de corps (6) vers ladite région de contact de corps (11),
g) remplir lesdites tranchées (9, 14) formées à l'étape f) avec un matériau isolant (20) et aplanir la surface de la structure résultante, et
h) finir ledit transistor.

2. Procédé selon la revendication 1, dans lequel ladite couche de semiconducteur (15) est une couche de silicium.

3. Procédé selon la revendication 1 ou 2, dans lequel ladite couche isolante enterrée (8) est une couche d'oxyde enterrée produite par implantation ionique d'oxygène dans une tranche de silicium vierge.

4. Procédé selon l'une quelconque des revendications 1 à 3, dans lequel lesdites étapes de gravure sont exécutées en utilisant une gravure ionique réactive.

5. Procédé selon l'une quelconque des revendications 1 à 4, dans lequel ledit matériau isolant (20) est du SiO₂.

6. Procédé selon l'une quelconque des revendications précédentes, dans lequel ladite étape d'aplanissement est exécutée par polissage chimico-mécanique.
